(19) Europäisches Patentamt / European Patent Office / Office européen des brevets

(11) **EP 2 707 738 B1**

(12) **FASCICULE DE BREVET EUROPEEN**

(45) Date de publication et mention
de la délivrance du brevet:
**22.07.2015 Bulletin 2015/30**

(21) Numéro de dépôt: **12722410.3**

(22) Date de dépôt: **12.04.2012**

(51) Int Cl.:
***G01R 31/36*** *(2006.01)*

(86) Numéro de dépôt international:
**PCT/FR2012/050802**

(87) Numéro de publication internationale:
**WO 2012/156605 (22.11.2012 Gazette 2012/47)**

(54) **PROCEDE D'ESTIMATION DE L'ETAT DE SANTE D'UNE BATTERIE ET SYSTEME DE GESTION DE BATTERIE ADAPTE**

VERFAHREN ZUR SCHÄTZUNG DER LEISTUNGSFÄHIGKEIT EINER BATTERIE UND ADAPTIERTES BATTERIEVERWALTUNGSSYSTEM

METHOD FOR ESTIMATING THE STATE-OF-HEALTH OF A BATTERY AND ADAPTED BATTERY MANAGEMENT SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2011 FR 1154160**

(43) Date de publication de la demande:
**19.03.2014 Bulletin 2014/12**

(73) Titulaire: **Valeo Equipements Electriques Moteur 94046 Créteil Cedex (FR)**

(72) Inventeur: **BENCHETRITE, Daniel**
**F-94000 Creteil (FR)**

(74) Mandataire: **Tran, Chi-Hai et al**
**Valeo Systèmes de Contrôle Moteur**
**Département Propriété Intellectuelle - PEL**
**Immeuble Le Delta**
**14, avenue des Béguines**
**BP 68532 Cedex**
**95892 Cergy-Pontoise (FR)**

(56) Documents cités:
**US-A1- 2007 001 679    US-A1- 2010 036 626**

• **JÜRGEN REMMLINGER ET AL: "State-of-health monitoring of lithium-ion batteries in electric vehicles by on-board internal resistance estimation", JOURNAL OF POWER SOURCES, vol. 196, no. 12, 20 août 2010 (2010-08-20), pages 5357-5363, XP055022208, ISSN: 0378-7753, DOI: 10.1016/j.jpowsour.2010.08.035**
• **BOSE C S C ET AL: "Battery state of health estimation through coup de fouet", TELECOMMUNICATIONS ENERGY CONFERENCE, 2000. INTELEC. TWENTY-SECOND INT ERNATIONAL SEPTEMBER 10-14, 2000, PISCATAWAY, NJ, USA,IEEE, 10 septembre 2000 (2000-09-10), pages 597-601, XP010523246, ISBN: 978-0-7803-6407-3 cité dans la demande**

**Description**

La présente invention concerne de manière générale l'estimation de l'état de santé d'une batterie de véhicule automobile à partir de la prise en compte d'une résistance électrique interne de la batterie. L'invention concerne également un capteur de mesure de batterie et un système de gestion de batterie adaptés à la mise en oeuvre du procédé de l'invention.

Des considérations d'économie d'énergie et de réduction de la pollution, surtout en milieu urbain, conduisent les constructeurs automobiles à proposer des véhicules tout électriques et des véhicules à bas $CO_2$ de types dits « micro-hybrid » « mild-hybrid » et « full-hybrid » (en terminologie anglaise). Ces technologies «micro-hybrid», «mild-hybrid» et «full-hybrid» correspondent à différents niveaux d'intégration des moyens électriques dans la propulsion des véhicules.

Ainsi, une technologie « micro-hybrid» connue de la présente demanderesse est basée sur. l'utilisation d'un alterno-démarreur associé à une fonction d'arrêt/relance automatique du moteur thermique. Les applications « mild-hybrid » intègrent généralement des moteurs électriques de l'ordre de 8 à 10 KW, par exemple, un moteur électrique monté en face avant d'un moteur thermique et couplé à celui-ci par une courroie de transmission. Il est possible avec un tel moteur électrique de réduire la cylindrée de la motorisation thermique (« engine downsizing » en terminologie anglaise) en prévoyant une assistance électrique en couple qui fournit un appoint de puissance notamment lors des reprises. De plus, une traction à faible vitesse, par exemple en environnement urbain, peut également être assurée par ce même moteur électrique. Les applications de type « full-hybrid» intègrent généralement des moteurs de 30 à 50 KW pour des architectures de type série et/ou parallèle avec un niveau d'intégration plus abouti du ou des moteurs électriques dans la chaîne de traction du véhicule.

Dans ces véhicules électrifiés, une parfaite maîtrise des batteries de stockage d'énergie électrique et de leur système de gestion est nécessaire. Les batteries doivent être gérées de manière optimale afin de les protéger contre toute détérioration, prolonger leur durée de vie, et les maintenir dans un état tel qu'elles puissent répondre aux demandes d'énergie provenant des différentes applications embarquées.

Différents concepts ont été proposés pour décrire l'état d'une batterie. Dans les véhicules automobiles, les indicateurs d'état SOC, SOH et SOF, respectivement, pour « State of Charge », « State of Health » et « State of Function » en terminologie anglaise, sont fréquemment utilisés. Ces indicateurs SOC, SOH et SOF peuvent être estimés dans un système de gestion de batterie dit BMS pour « Battery Management System » ou dans une unité électronique de commande du véhicule telle que l'unité VMU pour « Vehicle Management Unit ».

L'état de charge SOC se réfère au niveau d'énergie disponible dans la batterie et délivrable par celle-ci pour un travail effectif.

L'état de santé SOH se réfère au vieillissement de la batterie et peut être représenté par une durée de vie restante ou par un pourcentage de dégradation par rapport à des conditions initiales idéales (batterie neuve fournissant les performances spécifiées). Une évaluation simple du SOH, connue dans l'état de la technique, consiste à le déduire directement à partir d'une mesure de la résistance interne de la batterie.

L'état de fonctionnement SOF se réfère à la capacité de la batterie à remplir ou pas les missions qui lui incombent, comme par exemple fournir l'énergie nécessaire pour le démarrage du moteur thermique.

De manière générale, il est connu d'utiliser un capteur de mesure monté sur la batterie et qui fournit des mesures numériques d'échantillons prélevés pour le courant, la tension et la température de la batterie.

L'indicateur SOC peut être déduit à partir de la connaissance du couple courant-tension de la batterie et en intégrant le courant. L'indicateur SOF peut être déduit à partir de la connaissance de l'état de la batterie et des besoins en énergie des différentes applications.

Contrairement à l'évaluation du SOC et du SOF, l'évaluation d'un SOH pose davantage de difficultés car son concept n'est pas directement lié à des qualités physiques particulières. Aucun consensus n'existe dans l'industrie sur la détermination du SOH et différentes méthodes ont été proposées telles que celles reposant sur la résistance interne de la batterie, son courant de fuite, sa capacité à accepter la charge ou le nombre de cycles de charge/décharge de la batterie.

Pour les batteries au plomb, il est connu une méthode d'évaluation du SOH dite « du coup de fouet » qui a été décrite par Chasani S. C. Bose dans un article présenté à INTELEC 2000 (The Proceedings of The 22nd International Telecommunications Energy Conference, pp 597-601). Cette méthode exploite une corrélation mise en évidence entre la profondeur d'une chute de la tension batterie lors d'une décharge de celle-ci et un niveau de perte de capacité dû à son vieillissement. Un test de décharge partielle d'une durée relativement longue, de l'ordre 2 à 5 minutes, est nécessaire pour l'utilisation de cette méthode, ce qui la rend très intrusive pour certaines applications.

US 2007/001679 A1 (CHO IL ET AL, 4 janvier 2007) divulgue un procédé d'estimation de l'état de santé d'une batterie à l'aide de la résistance interne de la batterie.

Il est souhaitable de proposer de nouvelles solutions pour estimer de manière plus fine l'état de santé d'une batterie dans un véhicule automobile, et qui autorisent une intégration aisée vis-à-vis des applications automobiles embarquées.

Selon un premier aspect, la présente invention concerne un procédé d'estimation de l'état de santé d'une batterie équipant un véhicule automobile comprenant les étapes de mesurer une résistance interne et une température interne de la batterie, obtenir un état de charge de la batterie, et obtenir l'état de santé de la batterie au moyen d'une cartographie préétablie à laquelle sont appliqués en entrée la résistance, la température et l'état de charge.

Conformément à l'invention, caractérisé la mesure de la résistance interne de la batterie comporte, après une phase de repos de la batterie pendant laquelle son état de charge est demeuré stable, la phase de repos ayant une durée au moins égale à une durée prédéterminée, les étapes de :

d) activer une fenêtre temporelle de mesure de la résistance interne de la batterie pendant une durée prédéterminée lorsqu'une décharge de la batterie supérieure à une décharge de niveau prédéterminée est détectée;

e) dans la fenêtre temporelle, collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

f) calculer la résistance interne de la batterie à partir du couple de mesure tension-courant obtenu et d'un autre couple de valeurs tension-courant de la batterie mesuré pendant la phase de repos.

Selon une autre caractéristique, l'état de santé de la batterie est obtenu en faisant appel à une technique d'interpolation linéaire.

Selon un mode de réalisation particulier, l'interpolation linéaire est effectuée entre deux valeurs de résistance interne et deux valeurs d'état de santé qui bordent au plus près la résistance interne mesurée.

Selon encore une autre caractéristique, l'état de santé de la batterie est estimé en pourcentage entre 0% et 100%, la valeur de 0% correspondant à une batterie usagée à remplacer et la valeur de 100% correspondant à une batterie en parfait état et capable de fournir l'ensemble de ses performances spécifiées.

Selon une autre caractéristique, dans la fenêtre temporelle de mesure, la pluralité d'échantillons de mesure de la tension aux bornes de la batterie et la pluralité d'échantillons de mesure du courant délivré par la batterie sont obtenues chacune par un échantillonnage à une fréquence rapide de l'ordre de 1 khz.

Selon un autre aspect, l'invention concerne aussi un capteur de mesure de batterie pour la mise en oeuvre du procédé brièvement décrit ci-dessus.

Conformément à l'invention, le capteur comprend :

des moyens pour activer une fenêtre temporelle de mesure d'une résistance interne de la batterie pendant une durée prédéterminée lorsqu'une décharge de la batterie supérieure à une décharge de niveau prédéterminée est détectée;

des moyens, activés dans la fenêtre temporelle de mesure, pour collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

des moyens pour calculer la résistance interne de la batterie à partir du couple de mesure tension-courant fourni par les moyens pour collecter et rechercher et d'un autre couple de valeurs tension-courant de la batterie mesuré pendant une phase de repos de celle-ci.

Selon d'autres aspects, l'invention concerne aussi un système de gestion de batterie pour véhicule automobile comportant des moyens adaptés pour une mise en oeuvre du procédé brièvement décrit ci-dessus.

L'invention est maintenant décrite au travers de différents exemples de réalisation, en référence aux dessins ci-annexés. Il est à noter que ces dessins n'ont d'autre but que d'illustrer le texte de la description et ne constituent en aucune sorte une limitation de la portée de l'invention.

La Fig.1 est un bloc-diagramme d'une architecture de véhicule, représentée partiellement, montrant un système de propulsion de type « full-hydrid » associé à une unité d'alimentation à batterie, dans lesquels est intégrée une forme de réalisation de l'invention;

La Fig.2 montre un exemple de courbes de tension et de courant relatives à la batterie lors d'un démarrage d'un moteur thermique du véhicule; et

La Fig.3 montre, sous la forme d'un graphique en 3D, un exemple de cartographie utilisée dans le procédé d'estimation d'état de santé selon l'invention.

On notera ici, pour toute la description qui suit, qu'un signe positif est affecté à un courant de charge de la batterie et un signe négatif est affecté à un courant de décharge de la batterie.

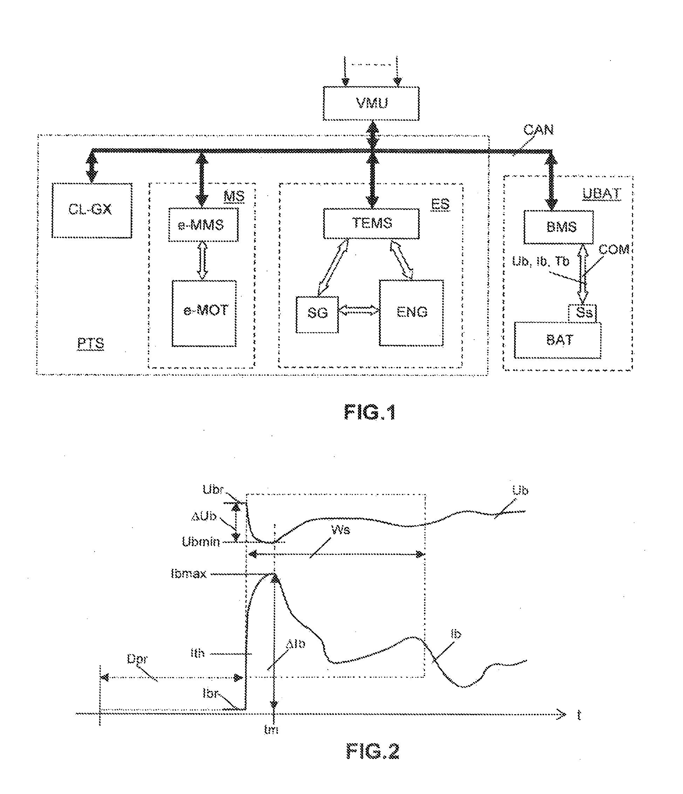

En référence à la Fig.1, il est décrit ci-après, de manière simplifiée, un système de propulsion PTS de type full-hybride associé à une unité de batterie d'alimentation UBAT.

Comme montré à la Fig.1, le système de propulsion PTS comprend une unité de propulsion thermique ES, une unité de propulsion électrique MS et un système d'embrayage/boîte de vitesses CL-GX. Le système d'embrayage/boîte de vitesses CL-GX est connu en soi par l'homme de métier et ne sera pas détaillé ici.

L'unité de propulsion thermique ES comporte essentiellement un moteur thermique ENG qui assure en mode thermique la traction du véhicule et dont le fonctionnement est contrôlé par un système de gestion de moteur thermique TEMS. Le moteur thermique ENG est équipé ici d'un alterno-démarreur SG qui assure les fonctions de démarreur du moteur thermique et de génératrice électrique pour l'alimentation en électricité du véhicule et notamment la recharge électrique de l'unité de batterie d'alimentation UBAT. Le fonctionnement de l'alterno-démarreur SG est ici contrôlé par le système TEMS.

L'unité de propulsion électrique MS comporte au moins un moteur électrique e-MOT dont le fonctionnement est contrôlé par un système de gestion de moteur électrique e-MMS. Le moteur électrique e-MOT assure en mode électrique la traction du véhicule. De même que l'alterno-démarreur SG, le moteur électrique e-MOT peut contribuer à une fonction de freinage récupératif dans un mode de fonctionnement en génératrice électrique. L'énergie électrique ainsi récupérée peut être stockée dans l'unité UBAT ou dans des supercondensateurs (non représentés).

Les unités de propulsion ES et MS peuvent fonctionner indépendamment en mode de traction thermique ou en mode de traction électrique ou bien fonctionner ensemble dans un mode mixte dans lequel le couple de traction de véhicule comporte une part d'origine thermique et une part d'origine électrique.

L'unité de batterie d'alimentation UBAT comporte essentiellement une batterie BAT équipée d'un capteur de mesure de batterie Ss et un système de gestion de batterie BMS.

On notera ici que les systèmes de gestion TEMS, e-MMS et BMS sont tous reliés à un bus de communication CAN du véhicule et peuvent échanger des informations entre eux ainsi qu'avec un système de gestion de véhicule VMU qui contrôle le fonctionnement général du véhicule. Les systèmes de gestion VMU, TEMS, e-MMS et BMS sont bâtis chacun autour d'une unité électronique de commande dédiée (non représentée).

Dans l'unité de batterie d'alimentation UBAT, le capteur de mesure de batterie Ss mesure la tension Ub aux bornes de la batterie BAT, le courant Ib qui la traverse, ainsi que sa température Tb. Des échantillons de mesure pour Ub, Ib et Tb sont prélevés et numérisés par le capteur Ss qui les transmet ensuite au système de gestion de batterie BMS à travers une liaison de communication COM. Le système BMS traite les mesures de Ub, Ib et Tb reçues en provenance du capteur Ss, à l'aide de modules logiciels résidents, et délivre sur le bus de communication CAN les indicateurs SOC, SOH et SOF décrivant la batterie BAT. Les indicateurs SOC, SOH et SOF sont transmis à travers le bus CAN aux unités électroniques de commande ayant besoin de ces informations pour le fonctionnement des applications embarquées du véhicule.

Bien entendu, l'architecture décrite brièvement ci-dessus n'est qu'un exemple de réalisation parmi de nombreuses configurations dans lesquelles l'invention peut être mise en oeuvre. Selon les applications dans les véhicules, différentes formes de réalisation et implantations des composants fonctionnels sont possibles. Ainsi, par exemple, l'indicateur SOF peut dans certains cas être calculé, non pas dans le système BMS, mais par exemple dans le VMU. Pour d'autres applications, la fonction BMS pourra être hébergée dans l'unité électronique d'un autre système de gestion et ne pas être supportée par une unité électronique dédiée.

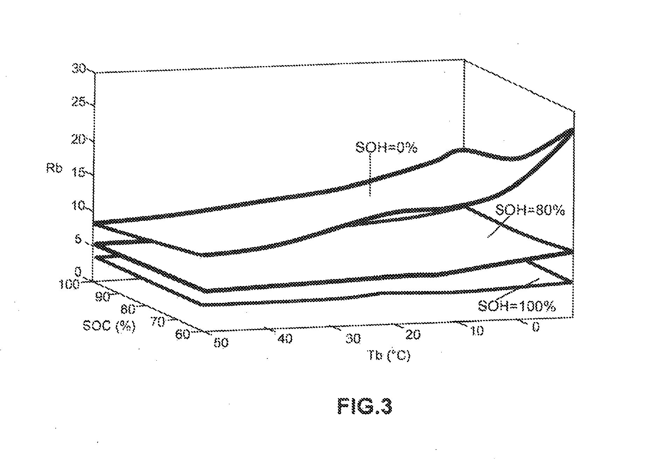

Le procédé de l'invention va maintenant être décrit en détail en référence plus particulièrement aux Figs.2 et 3.

Le procédé d'estimation de l'indicateur SOH selon l'invention demande une mesure préalable de la résistance interne Rb de la batterie BAT ainsi qu'une mesure de sa température interne Tb et la connaissance de la valeur de son indicateur SOC. Les différentes mesures nécessaires sont réalisées avec l'aide du capteur Ss.

La détermination de l'indicateur d'état de charge SOC d'une batterie et la mesure de sa température interne au moyen d'une sonde sont bien connues de l'homme du métier et ne seront donc pas décrites ici.

La résistance interne d'une batterie est une information souvent utilisée dans les véhicules automobiles actuels, par exemple, pour estimer la chute de tension lors d'une phase de démarrage du moteur thermique. Cette mesure de résistance interne nécessaire à la mise en oeuvre du procédé d'estimation de l'indicateur SOH selon l'invention peut donc avantageusement être utilisée par d'autres applications dans le véhicule.

La mesure de la résistance interne Rb de la batterie, conformément à l'invention, est maintenant décrite ci-après de manière détaillée en référence en particulier à la Fig.2.

La mesure de la résistance interne Rb est de préférence effectuée après une phase de repos de la batterie de durée Dpr. Cette durée de repos Dpr de la batterie dépendra bien entendu du type de la batterie. Pour une batterie au plomb, Dpr aura typiquement au moins une durée de l'ordre de 2 heures.

Les phases de repos qui précèdent la mesure de la résistance interne Rb sont typiquement des phases de stationnement du véhicule pendant lesquelles le courant de décharge consommé sur la batterie est relativement faible.

Pour réaliser la mesure de la résistance Rb, le capteur Ss doit être capable d'effectuer à une fréquence rapide des mesures simultanées de la tension et du courant, Ub et Ib, de batterie. Typiquement, une fréquence d'échantillonnage Fe de l'ordre de 1 kHz pourra être utilisée ici pour ces mesures.

On notera cependant que cette fréquence d'échantillonnage rapide Fe pour le fonctionnement du capteur Ss n'est requise que lors de la mesure de la résistance interne Rb conformément à l'invention. En dehors de ces phases de mesure, le capteur Ss pourra échantillonner à fréquence lente (de l'ordre de 5 Hz) pour la fourniture de ses mesures Ub, Ib et Ib au système de gestion de batterie BMS. Dans un mode de réalisation particulier de l'invention, le capteur Ss pourra fonctionner à fréquence lente lorsque le courant Ib charge la batterie BAT (c'est-à-dire, lorsque la batterie est rechargée par l'alternateur du véhicule), le fonctionnement à fréquence rapide Fe intervenant dès lors que le courant Ib devient un courant de décharge de la batterie BAT.

En référence à la Fig.2, lorsque le système BMS détecte, après une durée de repos Dpr, un courant de décharge important Ib fourni par la batterie BAT, une fenêtre Ws pour une mesure à fréquence rapide Fe est activée. Un tel courant de décharge important sera par exemple provoqué par le démarrage du moteur thermique ENG ou par l'activation d'un moteur électrique e-MOT.

La fenêtre Ws aura typiquement une durée de l'ordre de 100 ms. La fenêtre Ws est activée ici lorsque le courant de décharge Ib devient supérieur, en valeur absolue, à un seuil prédéterminé Ith. Selon une variante, la condition d'une pente du courant Ib supérieure à une valeur de seuil prédéterminée sera également nécessaire pour l'activation de la fenêtre de mesure Ws. Selon encore une autre variante, l'activation de la fenêtre Ws sera commandée à partir d'une détection faite sur la tension Ub et non sur le courant Ib. Pendant toute la durée de la fenêtre Ws, le courant Ib et la tension Ub sont mesurés par échantillonnage à la fréquence rapide Fe. Un processus de traitement hébergé dans le système BMS traite un flux de données numériques transmis par le capteur Ss et en extrait des données de mesure correspondant aux mesures des courant et tension Ib et Ub. Le processus de traitement effectue une recherche dans ces données de mesure extraites de manière à identifier un couple tension-courant (Ubmin, Ibmax) à un temps tm de la fenêtre de mesure Ws. Ubmin est la valeur de la tension Ub correspondant à une chute de tension maximale de celle-ci dans la fenêtre Ws. A Ubmin est associé le courant Ibmax qui correspond à une intensité maximale du courant Ib dans la fenêtre Ws.

Une fois déterminé le couple (Ubmin, Ibmax), la résistance interne Rb est donnée par la formule ci-dessous:

$$\text{Rb} = \Delta \text{Ub}/\Delta \text{Ib} = \text{Valeur Absolue } [(\text{Ubr-Ubmin})/(\text{Ibmax-Ibr})],$$

avec Ubr et Ibr qui sont les valeurs des tension et courant, Ub et Ib, de la batterie au repos, peu de temps avant le déclenchement de la fenêtre de mesure Ws.

On notera que la résistance interne Rb d'une batterie peut évoluer lorsque la batterie est sollicitée, ce qui se produit lorsque le véhicule est utilisé. C'est pour cette raison que selon l'invention la résistance interne de la batterie est mesurée après une longue période de repos, de manière à avoir une mesure en état stabilisée représentative d'un état général.

L'indicateur d'état de santé SOH est représentatif du vieillissement de la batterie, c'est-à-dire, d'un niveau de dégradation de celle-ci du fait des phénomènes de corrosion et de sulfatation.

Il peut être montré que le niveau de sulfatation de la batterie a une influence sur son état de charge SOC et que son niveau de corrosion a une influence sur sa résistance interne et sur sa température interne.

En estimant le SOH de la batterie à partir à la fois de son SOC, de sa résistance interne Rb et de sa température interne Tb, le procédé de l'invention fournit une estimation fine de l'état de santé de la batterie qui prend en compte les principales dégradations qui affectent celle-ci, à savoir, la sulfatation et la corrosion.

Conformément à l'invention, l'estimation du SOH de la batterie fait appel à une cartographie préalablement construite dont un exemple est représenté sous forme graphique en 3D à la Fig.3.

La construction de cette cartographie nécessite la préparation de plusieurs batteries ayant subi un vieillissement accéléré, ainsi que quelques caractérisations.

Un exemple de cycle de vieillissement de la batterie par corrosion est le suivant :

- la batterie est placée à 60°C dans une enceinte climatique pendant 3 semaines ;
- pendant ces 3 semaines, la tension de batterie est imposée à 14,2 V au moyen d'une charge batterie ; et
- après ces 3 semaines, la batterie est remisée à 25°C pendant une semaine, sans charge batterie.

Le cycle de vieillissement ci-dessus constitue une unité de corrosion.

Un certain nombre d'unités de corrosion peuvent ainsi être réalisées. Chaque unité de corrosion provoque un accroissement progressif de la résistance interne Rb de la batterie.

A l'issue de ces opérations de vieillissement des batteries, plusieurs batteries sont disponibles, chacune ayant une résistance interne Rb différente. Une batterie témoin n'ayant subi aucune unité de corrosion est également préparée.

Dans l'exemple correspondant à la cartographie de la Fig.2, six batteries ont été préparées au total. Une batterie témoin n'ayant subi aucune unité de corrosion et cinq batteries ayant subi de une à cinq unités de corrosion, respectivement.

Chacune des batteries est ensuite placée dans plusieurs états de charge (SOC) différents et à plusieurs températures internes (Tb) différentes pour chacun de ces états de charge. Pour chacune des batteries, une mesure de résistance interne (Rb) est effectuée pour chaque état de charge différent et chaque température interne différente. Ces mesures de résistance interne peuvent être effectuées avec un appareil de mesure classique disponible dans le commerce. L'ensemble des opérations décrites ci-dessus permettent de construire la cartographie nécessaire pour le procédé d'estimation de l'indicateur SOH selon l'invention.

Comme montré par l'exemple de la Fig.2, cette cartographie peut être représentée sous la forme d'un graphique en 3D dans lequel ont été reportées les mesures de résistance interne : Rb = f(SOC, Tb). Dans ce graphique, chaque nappe ou surface correspond à un SOH différent. La valeur du SOH est donné ici sous la forme d'un pourcentage (%). Les axes X, Y et Z de ce graphique 3D correspondent respectivement au SOC, à la température interne Tb et à la résistance interne Rb de la batterie.

Pour des raisons de simplicité, trois surfaces ou nappes correspondant respectivement à SOH=100%, SOH=80% et SOH=0% ont été représentées uniquement à la Fig.2. La valeur SOH=100% correspond ici à l'état de santé d'une batterie n'ayant subi aucune unité de corrosion, c'est-à-dire, la batterie témoin. La valeur SOH=80% correspond à une batterie ayant subi une unité de corrosion et la valeur SOH=0% correspond à une batterie ayant subi les 5 unités de corrosion.

Une fois connus le SOC, la résistance interne Rb et la température Tb de la batterie, le SOH correspondant est calculé par interpolation linéaire entre deux valeurs de Rb, R(a) et R(b), et deux valeurs de SOH, SOH(a) et SOH(b), qui bordent au plus près la mesure $\overline{R1}$ de la résistance interne Rb effectuée dans le fenêtre de mesure Ws, en appliquant l'égalité suivante :

$$SOH = SOH(a) + \frac{[SOH(b) - SOH(a)]}{[R(b) - R(a)]}[\overline{R1} - R(a)]\ .$$

Bien entendu, différentes variantes de réalisation de l'invention sont à la portée de l'homme du métier instruit par les enseignements qui lui sont apportés ici. Ainsi, par exemple, dans certaines applications, le traitement de calcul de la résistance interne de la batterie pourra être effectué par des moyens adaptés prévus dans le capteur Ss, soulageant ainsi le système BMS d'une charge de calcul. De plus, dans un tel cas, la liaison de communication COM pourra avoir un débit plus faible du fait qu'il deviendra alors inutile de transmettre au système BMS les mesures de Ub et Ib faites à la fréquence rapide Fe dans la fenêtre Ws.

**Revendications**

**1.** Procédé d'estimation de l'état de santé (SOH) d'une batterie (BAT) équipant un véhicule automobile comprenant les étapes de mesurer une résistance interne (Rb) et une température interne (Tb) de la batterie, obtenir (BMS) un état de charge (SOC) de la batterie, et obtenir l'état de santé (SOH) de la batterie au moyen d'une cartographie préétablie à laquelle sont appliqués en entrée la résistance (Rb), la température (Tb) et l'état de charge (SOC), **caractérisé en ce que** ladite mesure de la résistance interne de la batterie comporte, après une phase de repos de la batterie pendant laquelle son état de charge (SOC) est demeuré stable, ladite phase de repos ayant une durée (Dpr) au moins égale à une durée prédéterminée (2h), les étapes de :

d) activer une fenêtre temporelle de mesure (Ws) de la résistance interne (Rb) de la batterie pendant une durée prédéterminée (100 ms) lorsqu'une décharge (Ib) de la batterie supérieure à une décharge de niveau prédéterminée (Ith) est détecté;

e) dans ladite fenêtre temporelle (Ws), collecter une pluralité d'échantillons de mesure de la tension (Ub) aux bornes de la batterie et une pluralité d'échantillons de mesure du courant (Ib) délivré par la batterie et rechercher dans ces pluralités d'échantillons de mesure un couple de mesure tension-courant (Ubmin, Ibmax) correspondant, sensiblement à un même instant de mesure (tm), à un échantillon de mesure de tension de valeur minimale et un échantillon de mesure de courant de valeur maximale, ces valeurs minimale et maximale étant considérées en valeur absolue; et

f) calculer la résistance interne (Rb) de la batterie à partir du couple de mesure tension-courant (Ubmin, Ibmax) obtenu à l'étape e) ci-dessus et d'un autre couple de valeurs tension-courant (Ubr, Ibr) de la batterie mesuré pendant la phase de repos (Dpr).

2. Procédé selon la revendication 1, **caractérisé en ce que** l'état de santé (SOH) de la batterie est obtenu en faisant appel à une technique d'interpolation linéaire.

3. Procédé selon la revendication 2, **caractérisé en ce que** ladite interpolation linéaire est effectuée entre deux valeurs de résistance interne (R(a), R(b)) et deux valeurs d'état de santé (SOH(a), SOH(b)) qui bordent au plus près la résistance interne ($\overline{R1}$) mesurée.

4. Procédé selon l'une quelconque des revendications 1 à 3, **caractérisé en ce que** l'état de santé (SOH) de la batterie est estimé en pourcentage entre 0% et 100%, la valeur de 0% correspondant à une batterie usagée à remplacer et la valeur de 100% correspondant à une batterie en parfait état et capable de fournir l'ensemble de ses performances spécifiées.

5. Procédé selon l'une quelconque des revendications 1 à 4, **caractérisé en ce que** dans ladite fenêtre temporelle (Ws), ladite pluralité d'échantillons de mesure de la tension aux bornes de la batterie et ladite pluralité d'échantillons de mesure du courant délivré par la batterie sont obtenues chacune par un échantillonnage à une fréquence rapide de l'ordre de 1 khz.

6. Capteur de mesure de batterie pour la mise en oeuvre du procédé selon l'une quelconque des revendications 1 à 5, **caractérisé en ce qu'**il comprend :

des moyens pour activer une fenêtre temporelle de mesure (Ws) d'une résistance interne de la batterie pendant une durée prédéterminée lorsqu'une décharge de la batterie supérieure à une décharge de niveau prédéterminée est détectée;
des moyens, activés dans ladite fenêtre temporelle (Ws), pour collecter une pluralité d'échantillons de mesure de la tension aux bornes de la batterie et une pluralité d'échantillons de mesure du courant délivré par la batterie et rechercher dans lesdites pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et
des moyens pour calculer la résistance interne de la batterie à partir dudit couple de mesure tension-courant fourni par lesdits moyens pour collecter et rechercher et d'un autre couple de valeurs tension-courant de la batterie mesuré pendant une phase de repos de la batterie.

7. Système de gestion de batterie pour véhicule automobile, **caractérisé en ce qu'**il comprend des moyens adaptés pour une mise en oeuvre du procédé selon l'une quelconque des revendications 1 à 5.

**Patentansprüche**

1. Verfahren zur Schätzung der Leistungsfähigkeit (SOH) einer Batterie (BAT), mit der ein Kraftfahrzeug ausgestattet ist, umfassend die Schritte zum Messen eines Innenwiderstands (Rb) und einer Innentemperatur (Tb) der Batterie, zum Erhalten (BMS) eines Ladezustands (SOC) der Batterie, und zum Erhalten der Leistungsfähigkeit (SOH) der Batterie mithilfe einer vorher festgelegten Kartographie, auf der der Widerstand (Rb), die Temperatur (Tb) und der Ladezustand (SOC) eingetragen werden, **dadurch gekennzeichnet, dass** das Messen des Innenwiderstands der Batterie, nach einer Ruhephase der Batterie, während der ihr Ladezustand (SOC) stabil geblieben ist, wobei die Ruhephase eine Dauer (Dpr) aufweist, die mindestens gleich einer vorbestimmten Dauer (2 Std.) ist, die folgenden Schritte umfasst:

d) Aktivieren eines Messzeitfensters (Ws) des Innenwiderstands (Rb) der Batterie während einer vorbestimmten Dauer (100 ms), wenn eine Entladung (Ib) der Batterie oberhalb einer Entladung mit einem vorbestimmten Niveau (Ith) erfasst wird;
e) in dem Zeitfenster (Ws), Sammeln einer Vielzahl von Messproben der Spannung (Ub) an Klemmen der Batterie und einer Vielzahl von Messproben des Stroms (Ib), der von der Batterie geliefert wird, und Suchen in dieser Vielzahl von Messproben nach einem Messpaar Spannung-Strom (Ubmin, Ibmax), das, im Wesentlichen zum gleichen Messzeitpunkt (tm), einer Spannungsmessprobe mit einem Minimalwert und einer Strommessprobe mit einem Maximalwert entspricht, wobei diese Minimal- und Maximalwerte als Absolutwert angesehen werden; und

f) Berechnen des Innenwiderstands (Rb) der Batterie aus dem Messpaar Spannung-Strom (Ubmin, Ibmax), das in Schritt e) oben erhalten wurde, und einem anderen Wertepaar Spannung-Strom (Ubr, Ibr) der Batterie, das während der Ruhephase (Dpr) gemessen wurde.

2. Verfahren nach Anspruch 1, **dadurch gekennzeichnet, dass** die Leistungsfähigkeit (SOH) der Batterie erhalten wird, indem eine Technik zur linearen Interpolation angewendet wird.

3. Verfahren nach Anspruch 2, **dadurch gekennzeichnet, dass** die lineare Interpolation zwischen zwei Werten des Innenwiderstands (R(a), R(b)) und zwei Werten der Leistungsfähigkeit (SOH (a), SOH(b)) durchgeführt wird, die so nahe wie möglich am gemessenen Innenwiderstand ($\overline{R1}$) liegen.

4. Verfahren nach einem der Ansprüche 1 bis 3, **dadurch gekennzeichnet, dass** die Leistungsfähigkeit (SOH) der Batterie als Prozentsatz zwischen 0% und 100% geschätzt wird, wobei der Wert von 0% einer verbrauchten Batterie entspricht, die zu ersetzen ist, und der Wert von 100% einer Batterie entspricht, die sich in perfektem Zustand befindet und in der Lage ist, die Gesamtheit ihrer angegebenen Leistungen bereitzustellen.

5. Verfahren nach einem der Ansprüche 1 bis 4, **dadurch gekennzeichnet, dass** in dem Zeitfenster (Ws), die Vielzahl von Messproben der Spannung an den Klemmen der Batterie und die Vielzahl der Messproben des Stroms, der von der Batterie geliefert wird, jeweils durch eine Probenentnahme mit einer hohen Frequenz in der Größenordnung von 1 khz erhalten werden.

6. Batteriemesssensor zum Durchführen des Verfahrens nach einem der Ansprüche 1 bis 5, **dadurch gekennzeichnet, dass** er Folgendes umfasst:

Mittel zum Aktivieren eines Messzeitfensters (Ws) eines Innenwiderstands der Batterie während einer vorbestimmten Dauer, wenn eine Entladung der Batterie oberhalb einer Entladung mit einem vorbestimmten Niveau erfasst wird;

Mittel, die in dem Zeitfenster (Ws) aktiviert sind, zum Sammeln einer Vielzahl von Messproben der Spannung an Klemmen der Batterie und einer Vielzahl von Messproben des Stroms, der von der Batterie geliefert wird, und Suchen in dieser Vielzahl von Messproben nach einem Messpaar Spannung-Strom, das, im Wesentlichen zum gleichen Messzeitpunkt, einer Spannungsmessprobe mit einem Minimalwert und einer Strommessprobe mit einem Maximalwert entspricht, wobei diese Minimal- und Maximalwerte als Absolutwert angesehen werden; und

Mittel zum Berechnen des Innenwiderstands der Batterie aus dem Messpaar Spannung-Strom, das von den Mitteln zum Sammeln und Suchen und von einem anderen Wertepaar Spannung-Strom der Batterie, das während einer Ruhephase der Batterie gemessen wird, bereitgestellt wird.

7. Batterieverwaltungssystem für ein Kraftfahrzeug, **dadurch gekennzeichnet, dass** es adaptierte Mittel für die Durchführung des Verfahrens nach einem der Ansprüche 1 bis 5 umfasst.

**Claims**

1. Method for estimating the state of health (SOH) of a battery (BAT) with which a motor vehicle is equipped, comprising the step of measuring an internal resistance (Rb) and an internal temperature (Tb) of the battery, obtaining (BMS) a state of charge (SOC) of the battery, and obtaining the state of health (SOH) of the battery by means of a pre-established mapping to which the resistance (Rb), the temperature (Tb) and the state of charge (SOC) are applied as input, **characterized in that** said measurement of the internal resistance of the battery comprises, after a phase of rest of the battery during which its state of charge (SOC) remained stable, said rest phase having a duration (Dpr) at least equal to a predetermined duration (2h), the steps of:

d) activating a time window (Ws) for measuring the internal resistance (Rb) of the battery for a predetermined duration (100 ms) when a discharge (Ib) of the battery greater than a discharge of predetermined level (Ith) is detected;

e) in said time window (Ws), collecting a plurality of measurement samples of the voltage (Ub) at the terminals of the battery and a plurality of measurement samples of the current (Ib) delivered by the battery and searching, in these pluralities of measurement samples, for a voltage-current measurement pair (Ubmin, Ibmax) corresponding, substantially at one and the same measurement instant (tm), to a voltage measurement sample of minimum value and a current measurement sample of maximum value, these minimum and maximum values being considered as absolute values; and

f) calculating the internal resistance (Rb) of the battery from the voltage-current measurement pair (Ubmin, Ibmax) obtained in step e) above and another pair of voltage-current values (Ubr, Ibr) of the battery measured during the rest phase (Dpr).

2. Method according to Claim 1, **characterized in that** the state of health (SOH) of the battery is obtained by applying a linear interpolation technique.

3. Method according to Claim 2, **characterized in that** said linear interpolation is performed between two internal resistance values (R(a), R(b)) and two states of health values (SOH(a), SOH(b)) which flank the measured internal resistance ($\overline{R1}$) as closely as possible.

4. Method according to any one of Claims 1 to 3, **characterized in that** the state of health (SOH) of the battery is estimated as a percentage between 0% and 100%, the 0% value corresponding to a spent battery to be placed and the 100% value corresponding to a battery in a perfect state and capable of providing all its specified performance levels.

5. Method according to any one of Claims 1 to 4, **characterized in that** in said time window (Ws), said plurality of measurement samples of the voltage at the terminals of the battery and said plurality of measurements samples of the current delivered by the battery are each obtained by a sampling at a rapid frequency of the order of 1 khz.

6. Battery measurement sensor for implementing the method according to any one of Claims 1 to 5, **characterized in that** it comprises:

means for activating a time window (Ws) for measuring an internal resistance of the battery for a predetermined duration when a discharge of the battery greater than a discharge of predetermined level is detected:

means, activated in said time window (Ws), for collecting a plurality of measurement samples of the voltage at the terminals of the battery and a plurality of measurement samples of the current delivered by the battery and searching, in said plurality of measurement samples, for a voltage-current measurement pair corresponding, substantially at one and the same measurement instant, to a voltage measurement sample of minimum value and a current measurement sample of maximum value, these minimum and maximum values being considered as absolute values; and

means for calculating the internal resistance of the battery from said voltage-current measurement pair supplied by said means for collecting and searching and from another pair of voltage-current values of the battery measured during a phase of rest of the battery.

7. Battery management system for a motor vehicle, **characterized in that** it comprises means suitable for implementing the method according to any one of Claims 1 to 5.

EP 2 707 738 B1

FIG.1

FIG.2

10

FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007001679 A1, CHO IL

**Littérature non-brevet citée dans la description**

- **CHASANI S. C. BOSE.** *The Proceedings of The 22nd International Telecommunications Energy Conference,* 2000, 597-601